(19)

Europäisches Patentamt

European Patent Office

Office européen des brevets

(11) **EP 4 787 639 A1**

(12) **EUROPEAN PATENT APPLICATION**

(43) Date of publication:
**05.08.2026  Bulletin 2026/32**

(21) Application number: **26154054.6**

(22) Date of filing: **26.01.2026**

(51) International Patent Classification (IPC):
**H01S 5/10** (2021.01)          **H01S 5/14** (2006.01)
**H01S 5/06** (2006.01)

(52) Cooperative Patent Classification (CPC):
**H01S 5/142; H01S 5/1032; H01S 5/0612**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **31.01.2025  US 202519042461**

(71) Applicant: **Nokia Solutions and Networks Oy
02610 Espoo (FI)**

(72) Inventors:
• **GRILLANDA, Stefano**
  **Springfield, NJ (US)**
• **IDJADI, Mohamad Hossein**
  **c/o Nokia of America Corporation, Murray Hill, NJ
  (US)**
• **ASHTIANI, Farshid**
  **Berkeley Heights, NJ (US)**

(74) Representative: **Nokia EPO representatives
Nokia Technologies Oy
Karakaari 7
02610 Espoo (FI)**

(54)   **DUAL-WAVELENGTH LIGHT SOURCE**

(57)   A dual-wavelength light source includes a laser cavity and a tunable intra-cavity optical filter. The intra-cavity optical filter is implementable as an integrated photonic circuit and includes two serially coupled dual-ring resonators of different ring lengths. Each dual-ring resonator has a comb-like transmission spectrum including a sequence of tunable dual-peak transmission sub-bands. In operation, different dual-peak transmission subbands of the respective dual-ring resonators may be aligned using optical phase shifters to provide a tunable dual-peak passband of the inter-cavity optical filter. The peak-to-peak separation of the passband may be tuned by tuning optical coupling between the rings of the respective dual-ring resonator.

FIG. 3

EP 4 787 639 A1

## Description

## TECHNICAL FIELD

The present disclosure relates to integrated optical devices including light sources.

## BACKGROUND

Tunable laser sources are useful in a variety of measurement systems, including those based on optical frequency-domain reflectometry (OFDR). An OFDR system typically uses a swept-frequency or chirped-frequency laser to sense various disturbances along a fiber optic network, such as those affecting temperature, strain and stress of the fiber. Some advanced OFDR systems employ two tunable wavelengths instead of one to perform fiber sensing. Using two wavelengths with correlated optical phase noise may improve measurement sensitivity, increase the detection dynamic range, and reduce measurement time.

## SUMMARY

According to an example embodiment, provided is an apparatus comprising a light source. The light source comprises first and second optical reflectors, an optical gain element disposed in an optical path between the first and second optical reflectors, and an intra-cavity optical filter comprising first and second serially coupled dual-ring resonators disposed in the optical path between the first and second reflectors in series with the optical gain element.

In some implementations, each of the first and second serially coupled dual-ring resonators may comprise a first a micro-ring resonator side-coupled to a second micro-ring resonator. In some implementation, the first and second micro-ring resonators in each of the serially coupled dual-ring resonators may be of equal length. In some of such implementations, the first and second micro-ring resonators of the first dual-ring resonator may differ in length from the first and second micro-ring resonators of the second dual-ring resonator. In any of the above implementations, at least one of the first and second dual-ring resonators may comprise an optical phase shifter operable to align resonance frequencies of the first and second micro-ring resonators thereof. In any of the above implementations at least one of the first and second dual-ring resonators may comprise a tunable optical coupler configured to vary optical coupling between the first and second micro-ring resonators thereof. In any of the above implementations, the first micro-ring resonator in each of the first and second serially coupled dual-ring resonators may be double-coupled in the optical path between the first and second reflectors.

Any of the above implementations may include an optical coupler configured to optically couple the first micro-ring resonator of the first dual-ring resonator to the first micro-ring resonator of the second dual-ring resonator.

Any of the above implementations may include an optical phase shifter connected between the first micro-ring resonator of the first serially coupled dual-ring resonator and the first micro-ring resonator of the second serially coupled dual-ring resonator.

In any of the above implementations, the first and second dual-ring resonators may be configured to have a dual-peak transmission passband with a tunable center wavelength.

In any of the above implementations, the first and second dual-ring resonators may be configured to have a dual-peak transmission passband with a tunable peak separation.

Any of the above implementations may comprise an optical phase shifter connected in series with the intra-cavity optical filter between the first and second optical reflectors.

Any of the above implementations may comprise a third dual-ring resonator optically coupled in series with the first and second dual-ring resonators.

In any of the above implementations, the second optical reflector may comprise an optical loop mirror.

In any of the above implementations, the light source may comprise a photonic integrated circuit (PIC) including the intra-cavity optical filter. The PIC may also include the second optical reflector. In some implementations, the PIC may comprise a silicon photonic chip.

In any of the above implementations, the light source may comprise a reflective semiconductor optical amplifier integrating the first optical reflector and the optical gain element.

In any of the above implementations, the first and second serially coupled dual-ring resonators may be configured to have a comb-like transmission spectrum with a free spectral range of at least 2 THz.

A related aspect of the present disclosure provides an apparatus comprising a light source. The light source comprises first and second optical reflectors, an optical gain element disposed in an optical path between the first and second optical reflectors, and an intra-cavity optical filter comprising first and second serially coupled dual-ring resonators disposed in the optical path between the first and second reflectors in series with the optical gain element. Each of the first and second dual-ring resonators comprises a first micro-ring resonator side-coupled to a second micro-ring resonator, each of the micro-ring resonators comprising an optical phase shifter. The apparatus further comprises a controller configured to control the optical phase shifters to align resonance frequencies of the micro-ring resonators to a common resonance frequency to provide a dual-peak transmission passband centered at the common frequency. In some implementations, the controller may be further configured to operate the optical phase shifters to spectrally tune the dual-peak transmission passband. In some implementations, each of the dual-ring resonators may comprises a tunable coupler connecting the first and second micro-ring resonators thereof, and the controller may be configured to tune the tunable couplers to vary a peak-to-peak spacing of the dual-peak transmission passband.

A related aspect of the present disclosure provides an apparatus comprising an optical cavity, a light amplification means disposed in the optical cavity, and a light filtering means disposed in the optical cavity. The light filtering means comprises a pair of coupled optical resonators connected in series in the optical cavity. The pair of coupled optical resonators may comprise a first coupled-resonator means having an optical transmission spectrum comprising a first sequence of double-peak passbands and a first Free Spectral Range (FSR), and a second coupled-resonator means having an optical transmission spectrum comprising a second sequence of double-peak passbands and a second FSR different from the first FSR. In some implementations, the first and second coupled-resonator means are adaptable such that the respective double-peak passbands have approximately equal peak-to-peak spacing.

## BRIEF DESCRIPTION OF THE DRAWINGS

Embodiments disclosed herein will be described in greater detail with reference to the accompanying drawings that represent example embodiments thereof, which are not to scale, in which like elements are indicated with like reference numerals, and wherein:

FIG. 1 is a schematic diagram illustrating an integrated optical filter formed with a pair of side-coupled micro-ring resonators (MRRs);

FIG. 2 is a graph schematically illustrating a dual-peak transmission subband of the integrated optical filter of FIG. 1;

FIG. 3 is a diagram schematically illustrating a laser device including an intra-cavity filter with two pairs of side-coupled MRRs of FIG. 1 connected in series;

FIGs. 4A and 4B are diagrams schematically illustrating example optical transmission spectra of the two pairs of side-coupled MRRs of FIG. 3;

FIG. 5 is a diagram schematically illustrating a light-emitting apparatus including the laser device of FIG. 3 for generating a separate pair of tunable wavelengths;

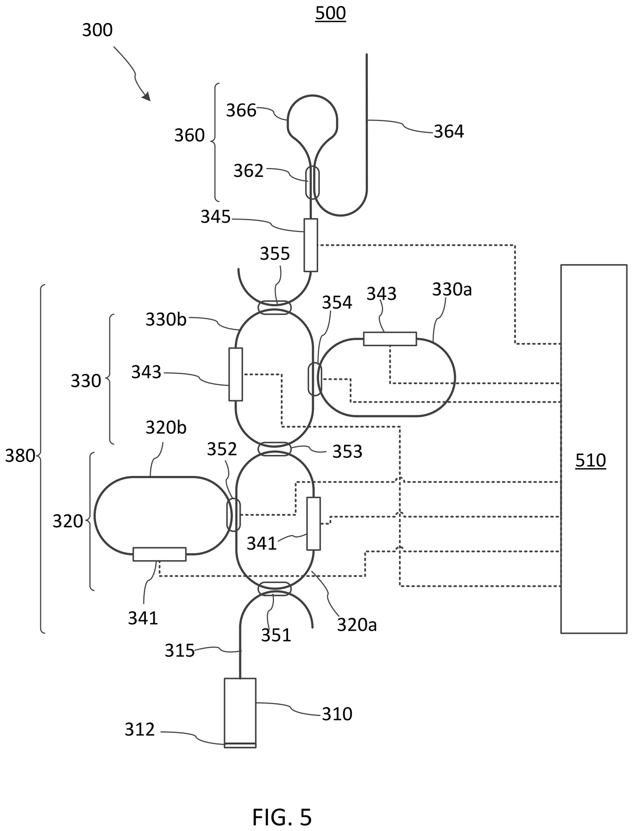

FIGa. 6A, 6B, and 6C are diagrams schematically illustrating a tuning of the center frequency of the separate pair of wavelengths generated by the apparatus of FIG. 5 according to a first example;

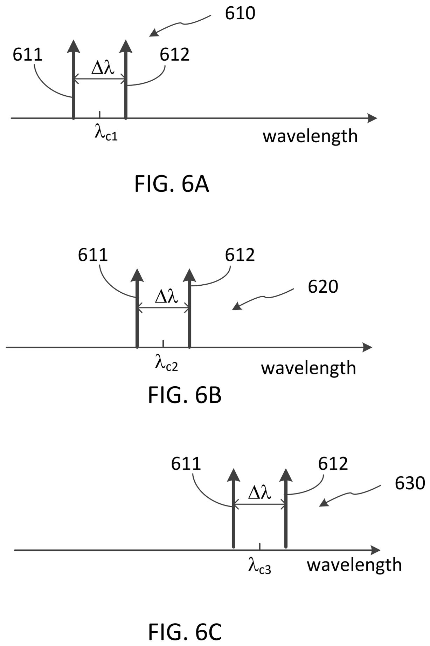

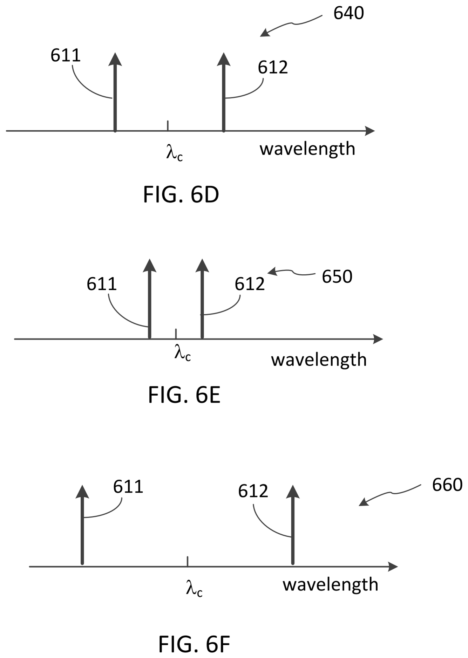

FIGs. 6D, 6E, and 6F are diagrams schematically illustrating a tuning of the wavelength separation of the separate pair of wavelengths generated by the apparatus of FIG. 5 according to a second example;

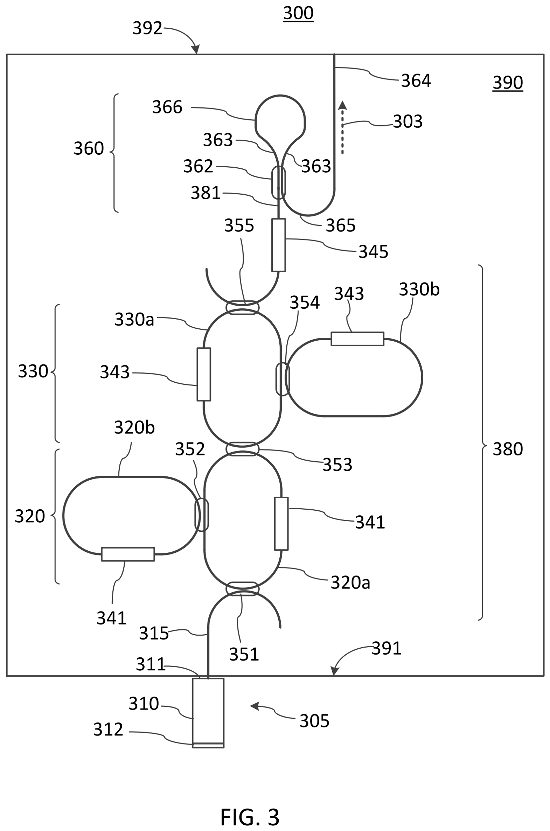

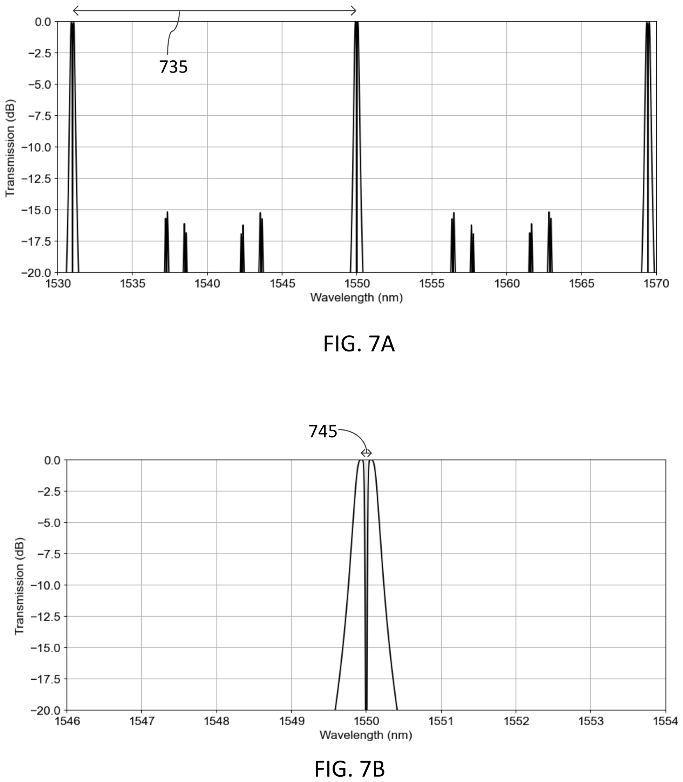

FIG. 7A is a graph illustrating an optical transmission spectrum computed for an example implementation of the intra-cavity filter of the laser device of FIG. 3;

FIG. 7B is a graph illustrating a zoomed-in portion of the optical transmission spectrum of FIG. 7A including one dual-peak transmission subband;

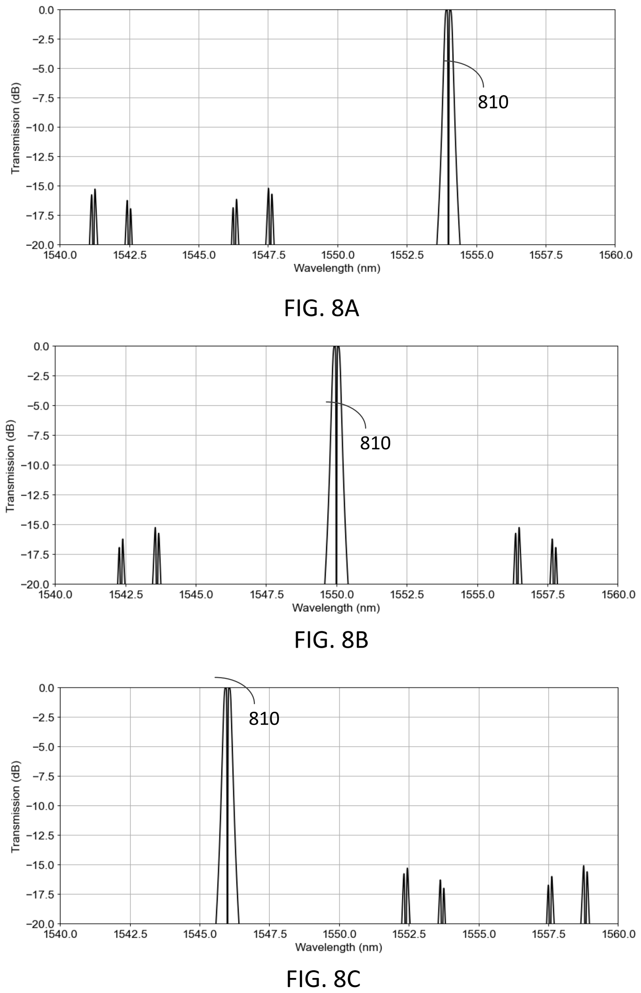

FIGs. 8A, 8B and 8C illustrate a tuning example of the transmission spectrum of FIG. 7A by varying optical phase shifters of the MRRs of the intra-cavity filter of the laser device of FIGs. 3 and 5;

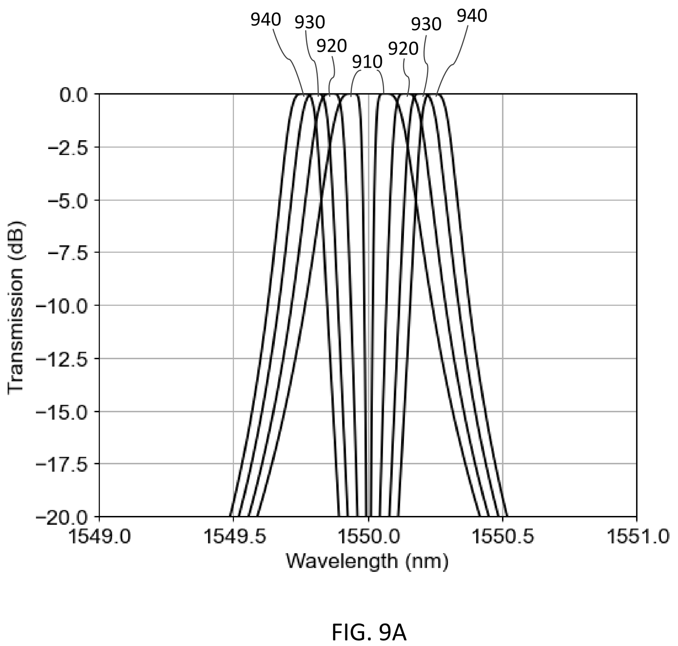

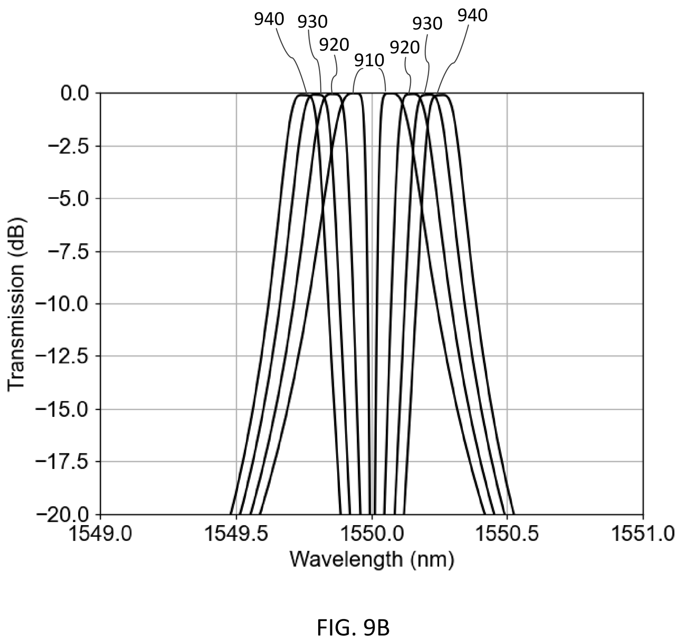

FIGs. 9A and 9B are graphs illustrating tuning of a spacing between the peaks of a dual-peak transmission subband of the intra-cavity filter of the laser device of FIGs. 3 and 5 for two different sets of the side coupling coefficients of one of the pairs of side-coupled MRRs;

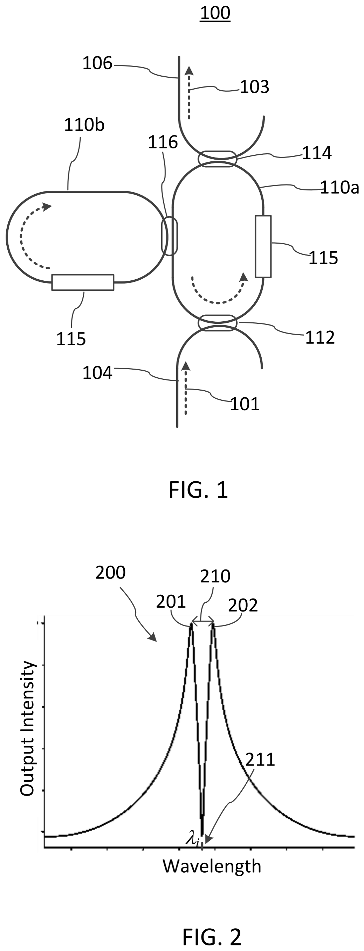

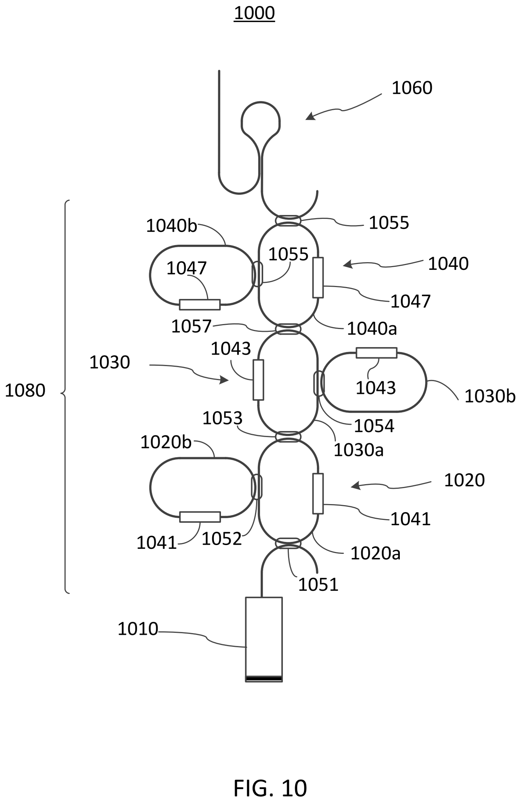

FIG. 10 is a diagram schematically illustrating a laser device including three pairs of side-coupled MRRs of FIG. 1 connected in series;

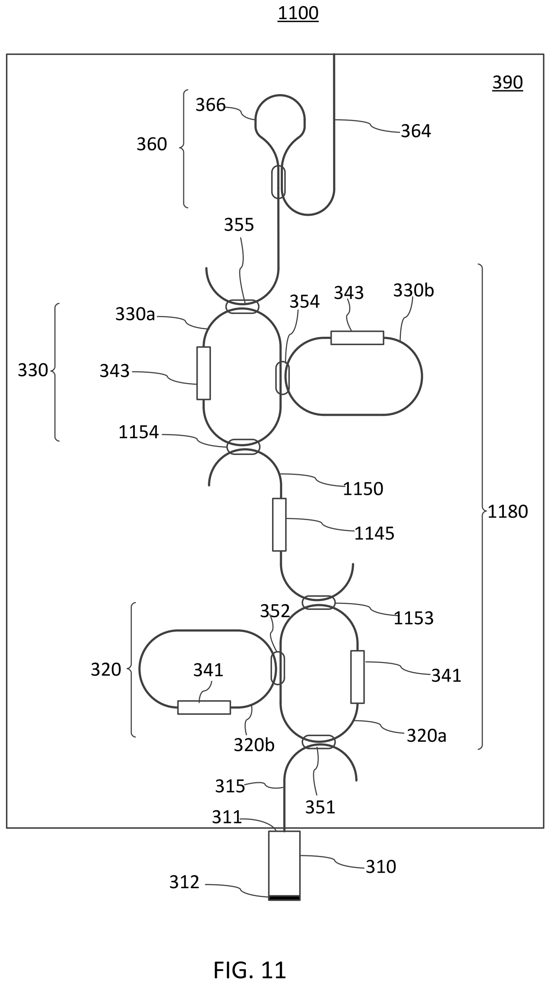

FIG. 11 is a diagram schematically illustrating a laser device including two pairs of side-coupled MRRs of FIG. 1 connected in series with a connecting waveguide;

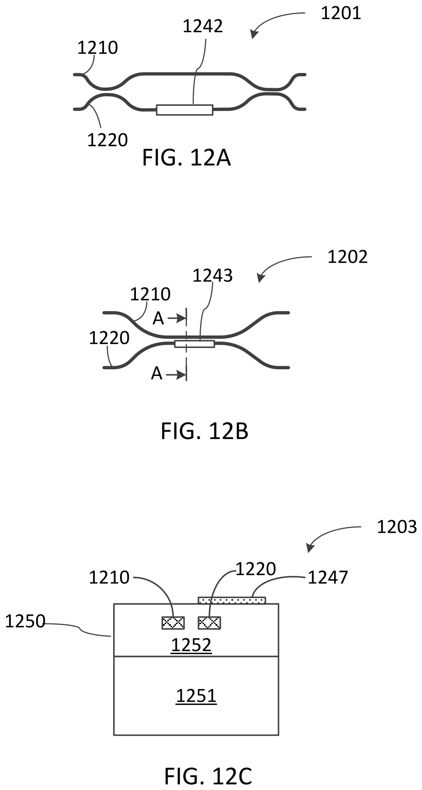

FIG. 12A is a schematic top view of an interferometric tunable optical coupler;

FIG. 12B is a schematic top view of an evanescent tunable optical coupler incorporating an offset heating element;

FIG. 12C is a schematic cross-sectional view of the evanescent tunable optical coupler of FIG. 12B.

## DETAILED DESCRIPTION OF SOME SPECIFIC EMBODIMENTS

In the following description, for purposes of explanation and not limitation, specific details are set forth, such as particular circuits, circuit components, techniques, etc. in order to provide a thorough understanding of the example embodiments described herein. However, it will be apparent to one skilled in the art that the present invention may be practiced in other embodiments that depart from these specific details. In other instances, detailed descriptions of well-known methods, devices, and circuits may be omitted so as not to obscure the description of the example embodiments. All statements herein reciting principles, aspects, and embodiments, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

Note that as used herein, the terms "first", "second", and so forth are not intended to imply sequential ordering, but rather are intended to distinguish one element from another, unless explicitly stated. Similarly, sequential ordering of method steps does not imply a requirement of sequential order of their execution, unless explicitly stated. The term "vertical" refers to a direction generally perpendicular to a surface of the substrate along which relevant integrated circuitry is disposed. The term "horizontal" refers to a direction along the surface of the substrate. The phrase "such as", when preceded by a comma ("... , such as ..."), means that the nouns introduced by "such as" must be understood as examples, not as definitions. In other words, the phrase "such as", when preceded by a comma, is synonymous with "e.g." or "for example".

Furthermore, the following abbreviations and acronyms may be used in the present document:

> "AR" Anti-Reflection
> "DRR" Dual-Ring Resonator
> "FSR" Free Spectral Range
> "MRR" Micro-Ring Resonator
> "PIC" Photonic Integrated Circuit
> "Si" Silicon
> "SiP" Silicon Photonics
> "SOI" Silicon on Insulator
> "SOA" Semiconductor Optical Amplifier
> "RSOA" Reflective Semiconductor Optical Amplifier
> "FWHM" Full Width at Half Maximum
> "DROW" Dual-Ring Optical Waveguide
> "MMI" Multimode Interference

Examples described below relate to an optical light source for simultaneously generating light at two spaced apart wavelengths using a shared gain element. In at least some implementations, the spacing between the two wavelengths and/or their central wavelength may be tuned in a broad spectral range, e.g. across a substantial portion of one of the O-band, C-band, L-band, or S-band of optical fiber communications. The two wavelengths generated by the laser device are expected to have correlated low-frequency phase noise, potentially enabling the use of the laser device in dual-wavelengths phase-sensitive OFDR systems.

FIG. 1 shows a schematic top view of an example dual-ring optical waveguide (DROW) filter that may be used in embodiments of the present disclosure. The DROW filter is configured as a Dual-Ring Resonator (DRR) 100 that includes a pair of side-coupled micro-ring resonators (MRRs) 110a and 110b, which are formed with optical waveguides, shown as solid black lines, and are disposed in an optical path between an input optical waveguide 104 and an output optical waveguide 106. The MRR 110a is coupled to the input waveguide 104 and the output waveguide 106 in a double-coupled configuration ("double-coupled MRR"), in which input light 101 enters the MRR 110a via a first optical coupler 112 and exits the MRR 110a as output light 103 via a second, different optical coupler 114. The double-coupled MRR 110a may also be referred to as the first MRR or the main MRR of the pair. The MRR 110b is optically coupled ("side-coupled") to the MRR 110a via a third, "side" optical coupler 116. In a side-coupled configuration of FIG. 1, a fraction of the output light 103 exits the first MRR 110a after one or more "side trips" in the second MRR 110b. A pair of side-coupled MRRs, such as MRRs 110a and 110b, that are connected as illustrated in FIG. 1 so that light enters and leaves the pair at respective locations along the same MRR (e.g., MRR 110a in FIG. 1) may also be referred to herein as a dual-ring resonator (DRR), or as a double-coupled DRR. The optical couplers 112, 114, and 116 are typically directional optical couplers, e.g. evanescent optical couplers or multimode interference (MMI) couplers.

In the example illustrated in FIG. 1, the MRRs 110a and 110b are shown to have a "racetrack" shape, with sections of straight optical waveguides connected between arc-shaped optical waveguides. In other implementations, the MRRs 110a, 110b may be ring-shaped optical waveguides, or may be in the form of some other closed optical waveguide loop.

An optical transmission spectrum of a double-coupled MRR, such as the MRR 110a in the absence of the MRR 110b, has a comb-like shape, with a series of periodic, or approximately periodic, transmission peaks at MRR resonances. The spacing between the MRR transmission peaks is referred to as the free spectral range (FSR). When the optical transmission spectrum is represented as a function of wavelength, the FSR of an MRR of length $l$ may be approximately given by equation (1):

$$\mathrm{FSR}_\lambda \cong \lambda^2 \Big/ l \cdot n_g \qquad (1)$$

where $\lambda$ is the wavelength of the input light 101, and $n_g$ is the group refractive index of a main mode of the optical waveguide forming the MRR. In an example case of a ring-shaped MRR, $l = 2\pi R$, where $R$ is the radius of the ring. For a race-track shaped MRR that additionally includes two straight waveguide segments of length $l_s$, the MRR length is $l = 2\pi R + 2l_s$. For a race-track shaped MRR that includes one or more additional waveguide segments, e.g. as a part of one or more directional couplers, the MRR length correspondingly increases by the length of added segments.

In an example implementation, the MRRs 110a and 110b have approximately the same length $l$, and therefore approximately the same FSR. At least one of the MRRs 110a, 110b may include an optical phase shifter 115, which may be used to align the resonance wavelengths of the MRRs 110a and 110b. With the individual resonances of the MRRs 110a and 110b aligned, the optical transmission spectrum of the DRR (DROW filter) 100 has a sequence of relatively narrow double-peak subbands, such as the transmission subband ("passband 200") illustrated in FIG. 2. Each of these transmission subbands has two peaks 201, 202 separated by a bandgap 210 centered at a common resonance wavelength 211 $\lambda_i$ of the MRRs 110a, 110b. The bandgap 210 between the peaks 201, 202, denoted $\Delta\lambda$, scales with a power coupling coefficient K of the side optical coupler 116 and the FSR of the MRRs 110a, 110b. In some approximation, the bandgap 210 may be proportional to a product of the square root of the power coupling coefficient K between the MRRs 110a, 110b and the common FSR of the MRRs 110a, 110b:

$$\Delta\lambda \sim \sqrt{K} \cdot \text{FSR}. \qquad (2)$$

FIG. 3 shows an example light source 300, which may be configured to operate as a laser capable of simultaneously generating light at two spaced apart wavelengths. Solid black lines indicate optical waveguides. The light source 300 includes an intra-cavity optical filter 380 connected in an optical path between a reflective gain element 305 and an optical reflector 360, which form a laser cavity of a Fabry-Perot type. The reflective gain element 305 includes an optical gain element 310 and an optical reflector 312, which may be, e.g., a reflective surface of the reflective gain element 305. The optical reflector 360 may be implemented as a waveguide reflector ("loop mirror 360") that includes a combination of a waveguide loop 366 and a four-port directional optical coupler 362 having an input port 381, an output port 365, and two loop ports 363 interconnected by the waveguide loop 366; this arrangement is also known as a Sagnac interferometer or a Sagnac loop. The input port 381 of the optical coupler 362 is connected to receive light from the intra-cavity optical filter 380, with the output port 365 being connected to an output optical waveguide 364 to output light 303 generated by the light source 300. The intra-cavity optical filter 380 and the optical reflector 360 may be implemented in a PIC 390, e.g. using a SiP or another suitable platform. The reflective gain element 305 may be, e.g., a reflective semiconductor optical amplifier (RSOA). The optical reflector 312 may be, e.g., a facet of the RSOA that is coated to have, e.g., close to 100% reflectivity in an operating wavelength range of the light source 300. The operating wavelength range of the light source 300 may be, by way of example and without limitation, the O-band, C-band, the S-band, and/or the L-band of optical fiber communications. The light source 300 may also be configured to operate in the visible part of the optical spectrum. A second, output end 311 of the reflective gain element 305 is optically coupled to the PIC 390, e.g., to an input optical waveguide 315 of the PIC 390. The second output end 311 may be, e.g., the other facet of the RSOA, which may be AR coated. Optical coupling between the reflective gain element 305 and the PIC 390 may be implemented, e.g., by direct butt-coupling of the RSOA chip to the PIC 390 or using one or more coupling lenses (such as ball lenses). A facet 391 of the PIC 390 that is proximate to the reflective gain element 305 may be angled to reduce back-reflections into the reflective gain element 305. Similarly, an output facet 392 of the PIC 390 distal to the reflective gain element 305 may be angled to reduce back-reflections into the light source 300 from external optical elements. Back reflections into the reflective gain element 305 and/or the light source 300 may also be reduced by having the input optical waveguide 315 and/or the output optical waveguide 364 terminate at the respective facets (input facet 391 and/or output facet 392) of the PIC 390 at an angle.

The intra-cavity optical filter 380 includes two pairs of side-coupled MRRs (first DRR 320 and second DRR 330) optically coupled in series. The pairs of side-coupled MRRs (first DRR 320 and second DRR 330) may each be an example of the DRR 100 described above. The first DRR 320 includes a double-coupled MRR 320a and a side MRR 320b that is coupled thereto via a "side" optical coupler 352. The second DRR 330 includes a double-coupled MRR 330a and a side MRR 330b coupled thereto by a "side" optical coupler 354. The MRRs 320a and 330a may also be referred to as the first MRRs or main MRRs of the respective DRRs. The MRRs 320a and 320b are double-coupled in the optical path between the first (312) and second (360) reflectors, i.e., each of the MRRs 320a and 330a transmit light propagating in the optical path between said reflectors 312, 360 via two different optical couplers. The MRRs 320a is optically coupled to the input optical waveguide 315 by a first optical coupler 351 and is optically coupled to the MRR 330a by a third optical coupler 353. The MRRs 330a is optically coupled to the optical reflector 360 via a fifth optical coupler 355 and is optically coupled to the MRR 330a by the third optical coupler 353. In the illustrated example, the third optical coupler 353 provides a serial optical connection between the two DRRs 320 and 330 by means of a direct optical coupling between the MRRs 320a and 330a. The fifth optical coupler 355 connects the MRR 330a to the input port 381 of the optical reflector 360. The optical couplers 351, 352, 353, and 362, as well as optical couplers 354, 355 described below, may be directional 2x2 optical couplers, e.g. evanescent optical couplers or MMI optical couplers.

In an example implementation, the MRRs 320a, 320b are of an approximately same first length $l_1$, and may each include an optical phase shifter 341 for fine-tuning the optical length of the respective MRR. The MRRs 330a, 330b may be of an approximately same

second length $l_2$ and may each include an optical phase shifter 343 for fine-tuning the optical length of the respective MRRs. The first length $l_1$ of the MRRs 320a and 320b typically differs from the second length $l_2$ of the MRRs 330a and 330b. An optical phase shifter 345 disposed outside of the MRRs in the optical path between the reflective gain element 305 and the optical reflector 360 may be used to fine-tune the optical path length between the reflective gain element 305 and the optical reflector 360, thereby tuning the resonant wavelengths of the Fabry-Perot cavity of the light source 300 to transmission peaks of the intra-cavity optical filter 380.

The intra-cavity optical filter 380 formed by the serially connected DRRs 320 and 330 may be, e.g., a Vernier-type optical filter, whose FSR is denoted herein $FSR_V$. In an example implementation, the DRRs 320 and 330 are configured such that, in operation their FSRs may be tuned to satisfy the following equation (2):

$$FSR_1 \cdot N_2 = FSR_2 \cdot N_1 = FSR_V, \qquad (3)$$

where $N_1 \neq N_2$ are integers. Here $FSR_V$ is the FSR of the intra-cavity optical filter 380 formed by the serially connected DRRs 320 and 330. With a suitable choice of the MRR lengths $l_1$ and $l_2$, the $FSR_V$ may span a large portion of, e.g., the O-band, C-band, the S-band, or the L-band of optical fiber communications. By way of a non-limiting example, $N_1$ and $N_2$ may be, e.g., 3 and 5, one of the FSR1 and FSR2 may be in a range from about 480 GHz to 720 GHz, the other one of the FSR1 and FSR2 may be in a range from about 800 GHz to 1200 GHz, and the $FSR_V$ may be, e.g., in a range from about 2400 GHz to 3600 GHz.

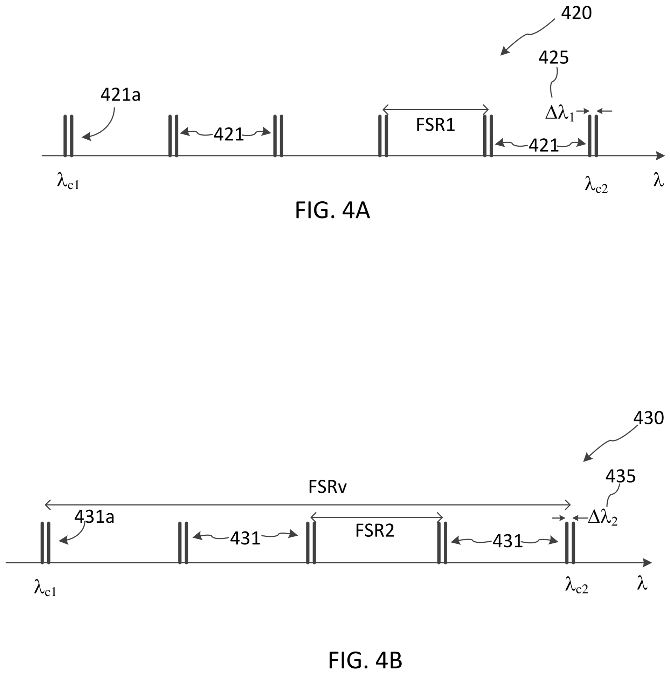

FIGs. 4A and 4B schematically show example optical transmission spectra 420 (FIG. 4A) and 430 (FIG. 4B) of the DRRs 320 and 330 for one possible choice of a ratio $N_1/N_2$ of the $FSR_1$ and $FSR_2$, i.e. $N_1=4$ and $N_2=5$. As shown in FIG. 4A, the optical transmission spectrum 420, e.g., of the DRR 320, includes an approximately periodic sequence of dual-peak transmission subbands 421 spaced by the $FSR_1$, with the peak spacing $\Delta\lambda_1$ 425 in each of the subbands 421. As shown in FIG. 4B, the optical transmission spectrum 430, e.g. of the DRR 330, includes an approximately periodic sequence of dual-peak transmission subbands 431 spaced by the $FSR_2$, with the peak spacing $\Delta\lambda_2$ 435 in each of the subbands 431. In the illustrated example, the MRRs 320a, 320b have a greater optical length than the MRRs 330a, 330b by a factor of 5/4. The MRRs 320a, 320b, 330a, and 330b are configured and/or tuned such that the peak spacing $\Delta\lambda_1$ 425 of the subbands 421 is approximately equal to the peak spacing $\Delta\lambda_2$ 435 of the sub-bands 431, i.e. $\Delta\lambda_1 \cong \Delta\lambda_2 = \Delta\lambda$, and such that each of the optical transmission spectra 420 and 430 has transmission subbands centered at a same pair of wavelengths $\lambda_{c1}$ and $\lambda_{c2}$ spaced by the FSRv. In a laser regime of operation, the reflective gain element 305 may have a greater optical gain near one of the two wavelengths $\lambda_{c1}$ and $\lambda_{c2}$, e.g. $\lambda_{c1}$ centering subbands 421a and 431a, and the light source 300 operating in the laser regime may simultaneously generate two peak wavelengths of the same subband, e.g., $\lambda_1 = (\lambda_{c1} - \Delta\lambda/2)$ and $\lambda_2 = (\lambda_{c1} + \Delta\lambda/2)$. Both the spacing between these two wavelengths and their spectral position may be tuned by tuning the two DRRs 320 and 330.

FIG. 5 illustrates an example apparatus 500 for generating two tunable wavelengths of light simultaneously. In the illustrated example, the apparatus 500 includes the light source 300 and a hardware controller 510 configured to tune various tunable elements of the light source 300. Similar to FIGs. 1 and 3, in FIG. 5 solid black lines indicate optical waveguides. The controller 510 may be electrically connected to the optical phase shifters 341 and 343 of the DRR 320 and the DRR 330, respectively, as indicated by dotted lines. In some implementations, the controller 510 may be also electrically connected to the optical phase shifter 345 disposed outside of the DRRs 320, 330 within the laser cavity. The phase shifters 341, 343, and 345 may be, e.g., thermal heaters configured to heat the optical waveguide of a respective MRR to fine-tune the optical length of the MRR. In other implementations, the phase shifters 341, 343, and 345 may be based on carrier injection, e.g. include a p/n or p/i/n junction, or some other mechanism suitable to vary the refractive index in one or more locations along the optical waveguide of a respective MRR. In some implementations, the controller 510 may be electrically connected to tune the optical coupler 362 to vary a fraction of light exiting the laser cavity.

In an example implementation, the side optical couplers 352 and 354 may be configured such that the subband peak spacing 425 of the DRR 320 and the subband peak spacing 435 of the DRR 330 have approximately the same value $\Delta\lambda$. This may include, for example, configuring the side optical couplers 352 and 354 such that one of these two couplers that couples MRRs of the greater length, and hence having a smaller FSR, has a greater ring-to-ring coupling coefficient. In example implementation, the ring-to-ring coupling coefficient K may be chosen so that the following equation (4) approximately holds:

$$\sqrt{K_2}\,FSR_1 \cong \sqrt{K_4}\,FSR_2 \qquad (4)$$

here $K_2$ is the power coupling coefficient of the side optical coupler 352 that couples the MRRs 320a, 320b of length $l_1$ and $FSR_1$, $K_4$ is the power coupling coefficient of the side optical coupler 354 that couples the MRRs 330a, 330b of length $l_2$ and $FSR_2$. The controller 510 may be configured to tune at least one of the optical phase shifters 341 to align the resonance wavelength combs of the MRRs 320a and 320b so that their respective resonance wavelengths at least approximately coincide, and the DRR 320 has the dual-peak subband structure such as illustrated in FIG. 4A and in FIG. 2. The controller 510 may be further configured to tune at least one of the optical phase shifters 343 to align the resonance wavelength combs of the MRRs 330a and 330b so that their respective resonance wavelengths at least approximately coincide, and the DRR 330 has the dual-peak sub-band structure such as that illustrated in FIG. 4B and in FIG. 2. For example, the resonance wavelengths of the MRRs 320a and 320b may be approximately aligned when the distance between them is smaller than a width (e.g., the full width at half maximum, "FWHM") of the corresponding resonance peaks in the transmission spectra thereof. Similarly, the resonance wavelengths of the MRRs 330a and 330b may be approximately aligned when the distance between them is smaller than a width (e.g., the FWHM) of the corresponding resonance peaks in the transmission spectra thereof. Typically, the FWHM of the resonance peaks in the transmission spectrum of an MRR is defined by a quality factor (the Q-factor) of the MRR.

In an example implementation, the controller 510 may be configured to tune the four optical phase shifters 341, 343 to simultaneously or sequentially shift in wavelength their respective optical transmission spectra, e.g. 420 and 430, so that the peak wavelengths $\lambda_1$ and $\lambda_2$ of the overlapping subbands, e.g. subbands 421a and 431a (FIGs. 4A and 4B), are shifted along the wavelength spectrum, together or relative to each other. This regime of wavelength tuning operation is schematically illustrated in FIGs. 6A-6C, which show, by way of example, three different dual-wavelength lasing spectra 610, 620, and 630, which the apparatus 500 may generate in operation when the controller 510 suitably tunes the optical phase shifters 341 and 343. In this example, the coupling coefficients $K_2$ and $K_4$ may remain unchanged, while the optical phase shifters 341 and 343 are tuned. The pair of generated wavelengths 611, 612 shifts across the spectrum, while the wavelength spacing $\Delta\lambda$ between them remains substantially unchanged.

In some implementations, the side optical couplers 352 and 354 may be tunable, with their respective coupling coefficients variable by the controller 510. In such implementations, the controller 510 may tune the wavelength spacing $\Delta\lambda = |\lambda_1 - \lambda_2|$ between the two generated wavelengths, $\lambda_1$ 611 and $\lambda_2$ 612, that may be generated by the apparatus 500 in a laser regime of operation. FIGs. 6D-6F schematically illustrate, by way of example, three different dual-wavelength lasing spectra 640, 650, and 660 that the apparatus 500 may generate by tuning the side optical couplers 352 and 354 with the controller 510. In this example, the resonance wavelengths of the MRRs, and hence the center wavelength $\lambda_c = (\lambda_1 + \lambda_2)/2$, are not changed, but the spacing between the generated wavelengths 611 and 612 varies. It will be appreciated that FIGs. 6A-6C and 6D-6F illustrate just two examples of operation of the apparatus 500, and the apparatus 500 is capable of other modes of operation, e.g. combining those illustrated in FIGs. 6A-6C and 6D-6F.

FIGs. 7A-9 illustrate example C-band ($\lambda \sim$ 1530-1565 nm) optical transmission spectra computed for an example intra-cavity optical filter 380 implemented in a silicon photonic (SiP) platform. In the simulations, the MRRs are formed with silicon waveguides having a thickness of 220 nm and a width of 500 nm, in a silicon dioxide cladding; with this choice of waveguide parameters, the waveguides support mono-mode propagation with quasi-transverse electric polarization (TE) in the C-band of optical communications.

FIGs. 7A and 7B illustrate an optical transmission spectrum of the SiP-based intra-cavity optical filter 380 described above with an example choice of the MRR lengths and coupling parameters. FIG. 7A shows the simulated optical transmission spectrum across the C-band, while FIG. 7B shows a zoomed-in portion of the transmission spectrum of the filter centered at one dual-peak transmission subband centered at 1550nm. In the example illustrated in FIGs. 7A and 7B, the length $l_1$ of each of the MRRs 320a, 320b is tuned to approximately 149.3 $\mu$m, and the length $l_2$ of each of the MRRs 330a, 330b is tuned to approximately 89.6 $\mu$m. With this choice of the MRR lengths, each of the MRRs 320a, 320b, 330a, 330b, as simulated, has a resonance at $\lambda_c$ = 1550 nm. The FSR of the intra-cavity optical filter 380 formed by the DRRs 320 and 330, $FSR_v$ (735, FIG. 7A) is about 19.2 nm (2400 GHz), i.e. slightly exceeds one half of the spectral width of the C-band. The values of the power coupling coefficients of the optical couplers 351, 353, and 355 were 0.254, 0.0128, and 0.1612, respectively. These values were chosen by way of example to simulate a Butterworth filtering shape. The values of the power coupling coefficients of the "side" optical couplers 352 and 354 are 0.01 and 0.0036, respectively, providing the wavelength spacing $\Delta\lambda$ (745, FIG. 7B) between the two peaks of the dual-peak transmission subbands of about 15 GHz.

FIGs. 8A-8C illustrate, by way of example, tuning of an optical passband 810 of the SiP-based intra-cavity optical filter 380 described above with reference to FIGs. 7A and 7B by fine-tuning the optical lengths of the MRRs, e.g., using the optical phase shifters 341 and 343. In this case, the coupling coefficients of the "side" optical couplers 352 and 354 stay constant, and the intra-peak spacing $\Delta\lambda$ remains about 15 GHz.

FIGs. 9A and 9B illustrate the effect of tuning the "side" couplers 352 and 354, without changing the MRR lengths, on the shape and intra-peak spacing of one dual-peak transmission subband at 1550nm. In FIG. 9A, the plotted curves represent the transmission subbands 910, 920, 930, and 940 of the transmission spectra of the dual-peak subband computed for four different pairs of $K_2$ and $K_4$ values, with $K_2$ equal respectively to 0.01 (910), 0.05 (920), 0.1 (930), and 0.15 (940) and K4 equal respectively to 0.0036 (910), 0.018 (920), 0.036 (930), 0.054 (940). In FIG. 9B, the transmission subbands 910, 920, 930, and 940 correspond to the same respective values of the coupling coefficient $K_2$, while the $K_4$ is, respectively,

0.004 (910), 0.02 (920), 0.04 (930), 0.06 (940), i.e. differ by about 10% from the respective $K_4$ used to generate the plots in FIG. 9A. In both configurations, the spacing $\Delta\lambda$ between the peaks of the transmission subband changes from about 15 GHz (910) to about 60 GHz (940), with the shape and amplitudes of the transmission subbands being fairly close for both choices of the $K_4$ coupling values. In these examples, the change of the wavelength spacing occurs without affecting the central wavelength of the laser cavity, which remains 1550 nm.

The example intra-cavity optical filter 380 described above has two serially connected DRRs; other implementations may include an inter-cavity optical filter with three or more DRRs connected in series. FIG. 10 illustrates a light source 1000 that includes three DRRs 1020, 1030, and 1040 optically connected in series between a reflective optical gain element 1010 and a loop waveguide mirror 1060 to form an intra-cavity tunable optical filter 1080. The reflective optical gain element 1010 and the loop waveguide mirror 1060 may be examples of the reflective optical gain element 305 and the optical reflector 360 described above. Each of the DRRs 1020, 1030, and 1040 includes a doubled-coupled MRR (1020a, 1030a, 1040a) and a side-coupled MRR (1020b, 1030b, 1040b), of approximately equal length, as described above with reference to the DRRs of FIGs. 1 and 3, coupled together by a side optical coupler (1052, 1054, 1058) which may be examples of the side optical couplers (352, 354) described above. The DRRs 1020 and 1030 may be examples of the DRRs 320 and 330 described above. The double-coupled MRR 1020a is optically coupled to the reflective optical gain element 1010 via a first optical coupler 1051 and to double-coupled MRR 1030a via third optical coupler 1053. In addition to being coupled to MRR 1020a, double-coupled MRR 1030a is also optically coupled to the double-coupled MRR 1040a via a seventh optical coupler 1057. In addition to being coupled to MRR 1030a, double-coupled MRR 1040a is coupled to the loop waveguide mirror 1060 via fifth optical coupler 1055 which may be an example of the fifth optical coupler (355) described above. First optical coupler 1051, third optical coupler 1053, and seventh optical coupler 1057 may be examples of first optical coupler 351 and third optical coupler 353 described above.

Each of the two MRRs (1040a, 1040b) of the DRR 1040 have an approximately equal length $l_3$ that is different from the lengths $l_1$ and $l_2$ of the MRRs (1020a, 1020b and 1030a, 1030b) comprising DRRs 1020 and 1030. In addition, each MRR (1020a, 1020b, 1030a, 1030b, 1040a, 1040b) includes an optical phase shifter (1041, 1043, 1047) for fine-tuning the optical length of the respective MRR. Optical phase shifters 1041, 1043, 1047 may be examples of the optical phase shifters (341, 343) described above. In an example implementation, the MRR lengths $l_1$, $l_2$ and $l_3$ may be such that the FSR of the DRR 1020, $FSR_1$, the FSR of DRR 1030, $FSR_2$, and the FSR of DRR 1040, $FSR_3$, approximately satisfy a relationship $FSR_1:FSR_2:FSR_3=N_1:N_2:N_3$. By way of non-limiting example, $FSR_1$ may be in a range from 960 GHz to 1200 GHz, $FSR_2$ may be in a range from 1600 GHz to 2000 GHz, and $FSR_3$ may be in a range from 1200 GHz to 1500 GHz. The intra-cavity optical filter 1080 may have a single dual-peak transmission subband in, e.g., the C-band of optical communications, ~ 1530-1565 nm, which may be tunable across the C-band. It is contemplated that by adding a fourth DRR into the sequence, a yet wider wavelength tunability of a single dual-peak transmission subband may be achieved.

In FIGs. 3, 5, and 10, successive DRRs are coupled directly via evanescent optical coupling between optical waveguides of the main double-coupled MRRs of the respective DRRs. In other embodiments, successive DRRs may be located at some distance from each other and coupled via a connecting optical waveguide.

FIG. 11 illustrates an example light source 1100 including such a cascaded DRR configuration with indirect DRR to DRR coupling. The light source 1100 is a modification of the light source 300 of FIGs. 3 and 5 wherein the MRRs 320a and 330a are moved some distance away from each other and are serially connected with two optical couplers 1153 and 1154 and a connecting optical waveguide 1150. The connecting optical waveguide 1150 may include an optical phase shifter 1145, which in this implementation may replace the optical phase shifter 345 of the light source 300. By tuning this phase shifter, resonance wavelengths of the Fabry-Perot cavity formed by the optical reflector 360 and the optical reflector 312 of the reflective gain element 305 may be tuned to correspond to the peak wavelengths $\lambda_1$ and $\lambda_2$ of the transmission spectrum of the intra-cavity optical filter 1180 formed by the DRRs 320 and 330 in this embodiment. In embodiments where the phase shifters of consecutive DRRs, such as the DRRs 320 and 330, are implemented using heaters, the arrangement of FIG. 11 may reduce thermal crosstalk between the consecutive DRRs compared to the direct-coupling configuration of FIGs. 3 and 5.

FIGs. 12A and 12B schematically illustrate, in a top view, two example configurations of a tunable optical coupler that may be used in embodiments of the present disclosure, e.g., to implement the "side" optical couplers 354 and 352. FIG. 12A illustrates an optical coupler 1201 wherein two optical waveguides 1210 and 1220 are routed to form a Mach-Zehnder interferometer (MZI) having an optical phase shifter 1242 in one of the MZI arms. The optical waveguides 1210 and 1220 may be the respective optical waveguides of the side-coupled MRRs, e.g. the MRRs 320a and 320b. FIG. 12B illustrates a directional optical coupler 1202 wherein the two optical waveguides 1210 and 1220 are routed to be close to each other over some length to allow a desired degree of evanescent optical coupling between the optical waveguides 1210 and 1220. An optical phase shifter 1243 is disposed to vary the speed of light propagation along the coupled length predominantly in one of the waveguides (waveguide 1220 in FIG. 12B), thereby varying the optical coupling between the waveguides.

FIG. 12C illustrates an example implementation 1203 of the optical coupler of FIG. 12B in a photonic chip 1250. FIG. 12C shows a simplified vertical cross-section of the chip 1250 along the line "A-A" indicated in FIG. 12B. In this example, the photonic chip 1250 includes a substrate 1251, e.g. a silicon or SOI substrate, with a cladding layer 1252 disposed over the substrate. The optical waveguides 1210 and 1220 may be, e.g., silicon or silicon nitride waveguides imbedded in the cladding layer 1252. In other implementations, the optical waveguides 1210 and 1220 may be implemented using other suitable optical materials. In the illustrated example, the optical phase shifter 1243 is implemented with a heating element 1247 disposed with an offset to heat the optical waveguide 1220 more than the optical waveguide 1210. In other implementation, one of the waveguides may include a p/n junction to vary the refractive index of the waveguide by varying an applied voltage.

One advantage of the example light sources described above is their potential ability to simultaneously generate, in a laser regime of operation, a separate pair of tunable wavelengths using a common gain element and a common photonic circuit as a shared laser cavity. Depending on implementation, in a dual DDR device such as that illustrated in FIGs. 3, 5, and 11, this pair of wavelengths may be tuned across a broad tuning range, e.g., over at least 1 THz, or at least 2 THz, e.g., across about a half of the C-band (~ 1530-1565 nm) of optical communications. The spacing between the wavelengths may also be tuned, e.g. from about 10-30 GHz to about 100 GHz or more. Using one single photonic circuit and one single gain section to generate the two widely tunable wavelengths may be preferable over having to use two different lasers, at least because it is likely to have a smaller footprint. Furthermore, since the two wavelengths use the same gain element and the same cavity, fluctuations of the pair of simultaneously generated wavelengths may be intrinsically correlated. These light sources therefore may be useful in such applications as two-wavelength phase-sensitive OTDR/OFDR systems.

The examples described above are not intended to be limiting, and many variations will become apparent to a skilled reader having the benefit of the present disclosure. For example, coupled MRRs described above may be implemented in a variety of material systems, including but not limited to silicon, silica, silicon nitride, silicon oxynitride, compound semiconductors such as, e.g., GaAs and InP based, polymer materials, and lithium niobate. In some implementations, side-coupled MRRs may have different lengths. Dual-wavelength optical sources that are based on these or other suitable materials may be configured to operate in different parts of optical spectrum, including but not limited to ultra-violate, visible, and infra-red. Furthermore, the light source of FIGs. 3, 5, 10, or 11 may be implemented entirely or in part with optical fibers, e.g. using an erbium-doped fiber amplifier (EDFA) or some other suitable fiber amplifier, followed by, e.g., an optical fiber loop reflector or a broad-band fiber Bragg grating as the shared reflective gain element. Furthermore, intra-cavity resonant filters having comb-like transmission spectra with periodic dual-peak transmission subbands may be implemented using other coupled resonators other than MRRs, e.g., with coupled Fabry-Perot etalons. A sequence of such coupled resonators may be used as intra-cavity optical filter of a dual-wavelength optical source.

According to an example embodiment disclosed above, e.g., in the summary section and/or in reference to any one or any combination of some or all of FIGs. 1-12C, provided is a light source (e.g. 300, FIG. 3; 500, FIG. 5; 1000, FIG. 10; 1100, FIG. 11). The light source comprises first and second optical reflectors (e.g. 312 and 360, FIGs. 3, 5, 11), an optical gain element (e.g. 310, FIGs. 3, 5, 11; 1010, FIG. 10) disposed in an optical path between the first and second optical reflectors, and an intra-cavity optical filter (e.g. 380, FIGs. 3, 5; 1080, FIG. 10; 1180, FIG. 11) comprising at least two serially coupled dual-ring resonators (e.g., 320 and 330, FIGs. 3, 5, 11; 1020, 1030, and 1040, FIG. 10) disposed in the optical path between the first and second reflectors in series with the optical gain element.

In some implementations, the light source may comprise an integrated photonic circuit (PIC) (e.g., 390, FIGs. 3, 5; 11). The PIC may comprise the intra-cavity optical filter, wherein each of the dual-ring resonators may be implemented with a pair of side-coupled micro-ring resonators (MRRs) (e.g., 320a,320b and 330a, 330b, FIGs. 3, 5, 11; 1020a, 1020b, and/or 1030a, 1030b, and/or 1040a, 1040b, FIG. 10). In some implementations, the second optical reflector may comprise an optical loop mirror (e.g. 366, FIGs. 3,5, 11) integrated with the PIC. In some implementations (e.g. FIGs. 3, 5, 10, 11), each of the pairs of side-coupled micro-ring resonators may comprise two side-coupled micro-ring resonators of equal length. In some implementations (e.g. FIGs. 3, 5, 10, 11), at least one of the pair of side-coupled micro-ring resonators may comprise an optical phase shifter (e.g. 341 or 343, FIGs. 3, 5, 10, 11), operable to align resonance frequencies of the pair of side-coupled micro-ring resonators. In any of the above implementations comprising at least two pairs of side-coupled micro-ring resonators (e.g. FIGs. 3, 5, 10, 11), at least one of the pairs of side-coupled micro-ring resonators may comprise a tunable optical coupler (e.g. 352 or 354, FIGs. 3, 5, 11; 1201, FIG. 12A; 1202, FIG. 12B; 1203, FIG. 12C), configured to vary optical coupling between the side-coupled micro-ring resonators of said pair.

In any of the above implementations (e.g. FIGs. 3,5,10,11), the light source may comprise a reflective semiconductor optical amplifier integrating the first optical reflector and the optical gain element.

Any of the above implementations may further comprise an optical phase shifter (e.g., 345, FIGs. 3,5; 1145, FIG. 11) connected in series with the intra-cavity optical filter between the first and second optical reflectors.

In any of the above implementations comprising at least two pairs of side-coupled micro-ring resonators, each of the pairs of side-coupled micro-ring resonators may comprise a first double-coupled micro-ring resonator (e.g. 320a or 330a, FIGs. 3,5, 11; 1020a, 1030a, or 1040a, FIG. 10) side-coupled to a second micro-ring resonator (e.g. 320b or 330b, FIGs. 3,5, 11; 1020b, 1030b, or 1040b, FIG. 10). In some implementations (e.g. FIGs. 3,5,10, 11), the first double-coupled micro-ring resonators of the pairs of side-coupled micro-ring resonators may have different ring lengths. In some implementations (e.g. FIGs. 3,5,10, 11), the pairs of side-coupled micro-ring resonators may be configured to have a comb-like transmission spectrum (e.g., FIG. 7A) with a free spectral range (e.g., $FSR_V$ 735, FIG. 7A) of at least 2 THz. Some implementations may comprise an optical coupler (e.g. 353, FIGs. 3,5, 1053, FIG. 10) configured to optically couple the at least two pairs of side-coupled micro-ring resonators with the first double-coupled micro-ring resonator of the first pair (e.g. 320a, FIGs. 3, 5; 1020a, FIG. 10) being coupled to the first doubled-coupled micro-ring resonator of the second pair (e.g. 330a, FIGs. 3, 5; 1030a, FIG. 10) by the optical coupler. Some implementations may comprise an optical phase shifter (e.g. 1145, FIG. 11) connected between the first double-coupled micro-ring resonator (e.g. 320a, FIG. 11) of the first pair of side-coupled micro-ring resonators and the first double coupled micro-ring resonator (e.g. 330a, FIG. 11) of the second pair of side-coupled micro-ring resonators.

In any of the above implementations comprising at least two pairs of side-coupled micro-ring resonators, each of the pairs of micro-ring resonators may be configured to have a dual-peak transmission passband (e.g., 200, FIG. 2; 421, 421a, 431, 431a, FIG. 4; 810, FIG. 8) with a tunable center wavelength.

In any of the above implementations, the two serially coupled dual-ring resonators may be configured to have a dual-peak transmission passband with a tunable peak separation (e.g., 910, 920, 930, and 940, FIGs. 9A and 9B).

In any of the above implementations comprising at least two pairs of side-coupled micro-ring resonators, each micro-ring resonator may comprise an optical phase shifter (e.g. 341, 343, FIGs. 3,5, 1041, 1043, 1047), and the light source may further comprise a controller (e.g., 510, FIG. 5) configured to control the optical phase shifters to align resonance frequencies of the side-coupled micro-ring resonators in each of the pairs to a common resonance frequency to provide a dual-peak transmission passband centered at the common frequency. In some implementations, the controller may be further configured to operate the optical phase shifters to spectrally tune the dual-peak transmission passband.

In some implementations, each of the at least two pairs of the of side-coupled micro-ring resonators may comprise a tunable coupler (e.g., 352, 354, FIGs. 3, 5, 11; 1052, 1054, 1058) connecting the micro-ring resonators of said pair, and the controller may be configured to tune the tunable couplers to vary a peak-to-peak spacing (e.g. 745, FIG. 7B) of the dual-peak transmission passband.

Any of the above implementations comprising at least two pairs of side-coupled micro-ring resonators may further comprise at least one other pair of side-coupled MRRs (e.g. 1040a, 1040b, FIG. 10) optically coupled in series with the two pairs of side-coupled MRRs (1020 and 1030, FIG. 10).

In any of the above implementations, the light source may comprise a silicon photonic chip. It will be further understood that various changes in the details, materials, and arrangements of the parts which have been described and illustrated in order to explain the nature of this disclosure may be made by those skilled in the art without departing from the scope of the disclosure, e.g., as expressed in the following claims.

Reference herein to "one embodiment" or "an embodiment" means that a particular feature, structure, or characteristic described in connection with the embodiment can be included in at least one embodiment of the disclosure. The appearances of the phrase "in one embodiment" in various places in the specification are not necessarily all referring to the same embodiment, nor are separate or alternative embodiments necessarily mutually exclusive of other embodiments. Various features described above with reference to a specific embodiment or embodiments may be combined with other embodiments. The same applies to the term "implementation."

Unless explicitly stated otherwise, each numerical value and range should be interpreted as being approximate as if the word "about" or "approximately" preceded the value or range.

The use of figure numbers and/or figure reference labels is intended to identify one or more possible embodiments of the claimed subject matter in order to facilitate the interpretation of the claim elements and equivalents. Such use is not to be construed as necessarily limiting the scope of those claims to the embodiments shown in the figures or described in the specification.

Furthermore, in the description above, for purposes of explanation and not limitation, specific details are set forth such as particular architectures, interfaces, techniques, etc. in order to provide a thorough understanding of the example embodiments described herein. In some instances, detailed descriptions of well-known devices, circuits, and methods are omitted so as not to obscure the description of the example embodiments with unnecessary detail. Thus, for example, it will be appreciated by those skilled in the art that block diagrams herein can represent conceptual views of illustrative circuitry embodying the principles of the technology. All statements herein reciting principles, aspects, and embodiments of the disclosure, as well as specific examples thereof, are intended to encompass both structural and functional equivalents thereof.

Thus, while example embodiments have been particularly shown and described with reference the figures, it will be understood by one skilled in the art that various changes in detail may be affected therein without departing from the spirit and scope of the invention as defined by the claims.

## Claims

1. A light source comprising:

    first and second optical reflectors;
    an optical gain element disposed in an optical path between the first and second optical reflectors; and
    an intra-cavity optical filter comprising first and second serially coupled dual-ring resonators disposed in the optical path between the first and second reflectors in series with the optical gain element.

2. The light source of claim 1, comprising an integrated photonic circuit (PIC), the PIC comprising the intra-cavity optical filter, wherein each of the first and second serially coupled dual-ring resonators comprises a first micro-ring resonator (MRR) side-coupled to a second micro-ring resonator.

3. The light source of claim 1, comprising a reflective semiconductor optical amplifier integrating the first optical reflector and the optical gain element.

4. The light source of claim 2, wherein the second optical reflector comprises an optical loop mirror integrated with the PIC.

5. The light source of claim 2, further comprising an optical phase shifter connected in series with the intra-cavity optical filter between the first and second optical reflectors.

6. The light source of claim 1, wherein each of the first and second serially coupled dual-ring resonators comprises a first micro-ring resonator side-coupled to a second micro-ring resonator of equal length.

7. The light source of claim 6, wherein at least one of the first and second micro-ring resonators of at least the first serially coupled dual-ring resonator comprises an optical phase shifter operable to align resonance frequencies of the first and second side-coupled micro-ring resonators in the first serially coupled dual-ring resonator.

8. The light source of claim 6, wherein the first serially coupled dual-ring resonator comprises a tunable optical coupler configured to vary optical coupling between the first and second micro-ring resonators of the first serially coupled dual-ring resonator.

9. The light source of claim 2, wherein the first micro-ring resonator in each of the first and second serially coupled dual-ring resonators is double-coupled in the optical path between the first and second reflectors.

10. The light source of claim 6, wherein the first and second side-coupled micro-ring resonators of the first dual-ring resonator differ in length from the first and second side-coupled micro-ring resonators of the second dual-ring resonator.

11. The light source of claim 2, wherein each of the first and second serially coupled dual-ring resonators is configured to have a dual-peak transmission passband with a tunable center wavelength.

12. The light source of claim 1, wherein each of the first and second serially coupled dual-ring is configured to have a dual-peak transmission passband with a tunable peak separation.

13. The light source of claim 2, wherein each of the first and second dual-ring resonators comprises an optical phase shifter, the light source further comprising a controller configured to tune the optical phase shifters to align resonance frequencies of each of the first and second micro-ring resonators of the first and second dual-ring resonators to a common resonance frequency to provide a dual-peak transmission passband centered at the common frequency.

14. The light source of claim 2, comprising a third dual-ring resonator optically coupled in series with the first and second dual-ring resonators.

15. A method for simultaneously generating light at two spaced apart wavelengths using a shared gain element comprising using a light source according to any of claims 1 to 14.

FIG. 1

FIG. 2

FIG. 3

FIG. 4A

FIG. 4B

EP 4 787 639 A1

FIG. 5

15

610

611    612

$\Delta\lambda$

$\lambda_{c1}$

wavelength

FIG. 6A

611    612

620

$\Delta\lambda$

$\lambda_{c2}$

wavelength

FIG. 6B

611    612

630

$\Delta\lambda$

$\lambda_{c3}$

wavelength

FIG. 6C

640

611

612

$\lambda_c$    wavelength

FIG. 6D

611    612    650

$\lambda_c$    wavelength

FIG. 6E

611    612    660

$\lambda_c$    wavelength

FIG. 6F

FIG. 7A

FIG. 7B

FIG. 8A

FIG. 8B

FIG. 8C

FIG. 9A

FIG. 9B

FIG. 10

1100

FIG. 11

1201

1242

1210

1220

FIG. 12A

1202

1243

1210

1220

A →

A →

FIG. 12B

1203

1210

1220

1247

1250

1252

1251

FIG. 12C

Europäisches
Patentamt

European
Patent Office

Office européen
des brevets

# EUROPEAN SEARCH REPORT

**Application Number**

EP 26 15 4054

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/049767 A1 (MORTON PAUL A [US] ET AL) 18 February 2016 (2016-02-18) | 1-5,9, 14,15 | INV. H01S5/10 |
| A | * paragraph [0035]; figure 11 * | 6-8, 10-13 | H01S5/14 |
| X | US 2017/179671 A1 (TAKABAYASHI KAZUMASA [JP] ET AL) 22 June 2017 (2017-06-22) * paragraphs [0042] - [0073], [0133]; figures 4,7,8 * | 1-5,9,15 | ADD. H01S5/06 |
| A | ZHANG YUNDONG ET AL: "Series-coupled fiber double-ring in Mach-Zehnder interferometer for temperature sensing", SPIE OPTICAL ENGINEERING + APPLICATIONS, 2015-08-09¦2015-08-13, SAN DIEGO, CALIFORNIA, UNITED STATES ; 2015-08-28 ; SPIE ; 1000 20TH ST. BELLINGHAM WA 98225-6705 USA, vol. 9609, 28 August 2015 (2015-08-28), pages 96090I-96090I, XP060060512, ISSN: 0277-786X, DOI: 10.1117/12.2187175 ISBN: 978-1-62841-775-3 * pages 2,3; figures 1,2 * | 1,6,11 | |
| A | US 2021/021100 A1 (MELIKYAN ARGISHTI [US] ET AL) 21 January 2021 (2021-01-21) * paragraph [0056]; figure 5 * | 1,15 | |

**TECHNICAL FIELDS SEARCHED (IPC)**

H01S

The present search report has been drawn up for all claims

| Place of search | Date of completion of the search | Examiner |
|---|---|---|
| Munich | 23 June 2026 | Riechel, Stefan |

EPO FORM 1503 03.82 (P04C01)

## ANNEX TO THE EUROPEAN SEARCH REPORT
## ON EUROPEAN PATENT APPLICATION NO.

EP 26 15 4054

This annex lists the patent family members relating to the patent documents cited in the above-mentioned European search report.
The members are as contained in the European Patent Office EDP file on
The European Patent Office is in no way liable for these particulars which are merely given for the purpose of information.

23-06-2026

| Patent document cited in search report | Publication date | Patent family member(s) | Publication date |
|---|---|---|---|
| US 2016049767 A1 | 18-02-2016 | NONE | |
| US 2017179671 A1 | 22-06-2017 | JP 6274322 B2 | 07-02-2018 |
| | | JP WO2016042658 A1 | 15-06-2017 |
| | | US 2017179671 A1 | 22-06-2017 |
| | | WO 2016042658 A1 | 24-03-2016 |
| US 2021021100 A1 | 21-01-2021 | NONE | |